# EUROPÄISCHE PATENTSCHRIFT

(11) **EP 3 379 351 B1**
(45) Veröffentlichungstag und Bekanntmachung des Hinweises auf die Patenterteilung: **29.04.2020**
(21) Anmeldenummer: 17162415.8
(22) Anmeldetag: 22.03.2017
(51) Int. Cl.: G05B 17/02, G05B 19/418

(54) **VERFAHREN ZUM BETREIBEN EINER AUTOMATISIERUNGSEINRICHTUNG SOWIE AUTOMATISIERUNGSEINRICHTUNG**
METHOD FOR OPERATING AN AUTOMATION DEVICE AND AUTOMATION DEVICE
PROCÉDÉ DE FONCTIONNEMENT D'UN DISPOSITIF D'AUTOMATISATION ET DISPOSITIF D'AUTOMATISATION

(43) Veröffentlichungstag der Anmeldung: 26.09.2018
(73) Patentinhaber: Siemens Aktiengesellschaft, 80333 München (DE)
(72) Erfinder: Lutz, Benjamin, 76327 Pfinztal (DE); Palmin, Anna, 76187 Karlsruhe (DE)

(56) Entgegenhaltungen:
- EP-A1- 1 944 663
- EP-A1- 3 121 667
- US-B2- 9 442 475

## Beschreibung

Die Erfindung betrifft ein Verfahren zum Betreiben einer Automatisierungseinrichtung gemäß dem Oberbegriff des Anspruchs 1. Darüber hinaus betrifft die Erfindung eine Automatisierungseinrichtung gemäß dem Oberbegriff des Anspruchs 3.

Aus dem Siemens-Katalog "ST PCS 7 T", Kapitel 8, Ausgabe 2016 ist ein Simulations-Werkzeug offenbart, welches eine Echtzeitsimulation von Automatisierungslösungen ermöglicht. Dieses Simulations-Werkzeug umfasst ein Simulations-Framework, welche das Prozessverhalten der Feldgeräteebene simuliert, und eine Simulations-Einheit bzw. ein Simulations-Interface, welches das Kommunikationsverhalten der realen Feldgeräte simuliert, wobei ferner diese Simulations-Einheit das modellierte Prozessverhalten an die Steuerung anbindet.

In der US 9 442 475 B2, der EP 1 944 663 A1 und der EP 3 121 667 A1 sind Verfahren zur Simulation eines Prozessverhaltens innerhalb einer Prozessanlage offenbart.

Sowohl in der Fertigungs- als auch in der Prozessindustrie sind zum Testen und/oder zur Inbetriebnahme von projektspezifischen Steuerprogrammen von Automatisierungsgeräten Testumgebungen ohne reale Automatisierungskomponenten vorgesehen, wobei unterschiedliche Virtualisierungsansätze unterstützt werden. Beispielsweise können mittels des aus dem genannten Siemens-Katalog bekannten Simulations- und Trainingssystems Prozessmodelle der Anlagen erzeugt und simuliert werden. Die Prozessmodelle können dann per "Software in the Loop" (SIL) mit einer virtuellen Steuerung gekoppelt werden oder als "Hardware in the Loop" (HIL) mit realen Automatisierungsgeräten und einer Hardware-Anschaltung in Form eines Simulations-Interfaces betrieben werden, welche die reale und unterlagerte Feldebene virtualisiert. Die reale Feldebene umfasst gewöhnlich an einen Feldbus angeschlossene dezentrale Peripherien, die jeweils mit einer Interface-Baugruppe zum Anschluss an den Feldbus und mit einer Vielzahl von Prozesseingabe- und Prozessausgabe-Baugruppen versehen sind, wobei an die jeweiligen Prozesseingabe-Baugruppen Sensoren und an die jeweiligen Prozessausgabe-Baugruppen Aktuatoren angeschlossen sind.

Gewöhnlich wird im Hinblick auf den Funktionsnachweis einer Anlage im Rahmen eines so genannten "Factory Acceptance Tests" (FAT) ein Test mit einer Vielzahl von Simulationsmodellen bewerkstelligt. Dazu muss der Nachweis erbracht werden, dass der Test mit den dazu gewünschten bzw. vorgesehenen Simulationsmodellen durchgeführt wurde. Es ist daher wünschenswert zu erkennen, ob während des Tests Simulationsmodelle versehentlich ausgetauscht und/oder falsch parametriert wurden.

Der Erfindung liegt daher die Aufgabe zugrunde, ein Verfahren gemäß dem Oberbegriff des Anspruchs 1 anzugeben, mittels der, insbesondere im Rahmen eines so genannten "Factory Acceptance Tests" (FAT), vereinfacht nachgewiesen werden kann, ob für eine Simulation eines Prozessverhaltens von Sensoren und/oder Aktuatoren vorgesehene Simulationsmodelle für eine Simulation verwendet wurden. Darüber hinaus ist eine Automatisierungseinrichtung gemäß dem Oberbegriff des Anspruchs 3 zu schaffen, die zur Durchführung des Verfahrens geeignet ist.

Diese Aufgabe wird im Hinblick auf das Verfahren durch die im kennzeichnenden Teil des Anspruchs 1 angegebenen, bezüglich der Automatisierungseinrichtung durch die im kennzeichnenden Teil des Anspruchs 3 angegebenen Maßnahmen gelöst.

Vorteilhaft ist, dass jederzeit zur Laufzeit eines "Factory Acceptance Tests" (FAT) nachvollzogen werden kann, welche Simulationsmodelle gerade genutzt werden und wie diese parametriert sind. Dies bedeutet eine Fehlerminimierung, insbesondere deshalb, weil bzgl. verfahrenstechnischer Anlagen mit einer Vielzahl von Simulationsmodellen getestet wird.

Mittels der im Patentanspruch 2 angegebenen Maßnahmen wird eine Überprüfung der Integrität sowie der Authentizität der Simulationsmodelle weiter vereinfacht. Dadurch können nicht autorisierte Änderungen an den Simulationsmodellen sowie die Echtheit der Simulationsmodelle (Prüfung bzgl. des Originals des jeweiligen Modells) leichter erkannt werden.

Mittels der angegebenen Maßnahmen ist es während des gesamten Factory Acceptance Tests (HIL, SIL) möglich, die zu Grunde liegenden Simulationsmodelle zu erfassen, zu visualisieren und darüber hinaus auf Integrität, Authentizität und somit die Echtheit (originality) zu überprüfen und Änderungen zu erkennen. Ferner werden alle Vorgänge für die Nachvollziehbarkeit eines Factory Acceptance Tests (Audit Trail) festgehalten, wobei diese Vorgänge nahtlos in die in den Test vorgesehenen Komponenten der Automatisierungseinrichtung bzw. des Leitsystems (Steuerung, Operator-System, Server) integriert sind. Die Signatur der jeweiligen Simulationsmodelle wird im Operator-System z. B. im Rahmen einer Initialisierung und zur Laufzeit überprüft, wobei insbesondere ein Augenmerk auf die Integrität, Authentizität und Echtheit der so genannten Metadaten gelegt wird. Ein Prüfwert in Form eines Hash-Wert der "korrekten" Metadaten zu einem Simulationsmodell wird zum Bestandteil eines so genannten Simulationsmodellzertifikats, welches unter anderem den zur Verifikation der Simulationsmodellsignatur zu verwendenden Public Key einer Entwicklungsabteilung beinhaltet, die das Simulationsmodell entwickelt hat. Eine Service-Einheit ist vorgesehen zur Überwachung der geladenen Simulationsmodelle auf Änderungen und kann zur situationsbedingten Erzeugung von Meldungen genutzt werden.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figuren 1 und 4: Bestandteile einer Automatisierungseinrichtung,
- Figur 2: Metadaten und ein Simulationsmodell-Zertifikat und
- Figur 3: eine hierarchische Baumstruktur.
Die in den Figuren 1 bis 4 dargestellten gleichen Teile sind mit gleichen Bezugszeichen versehen.

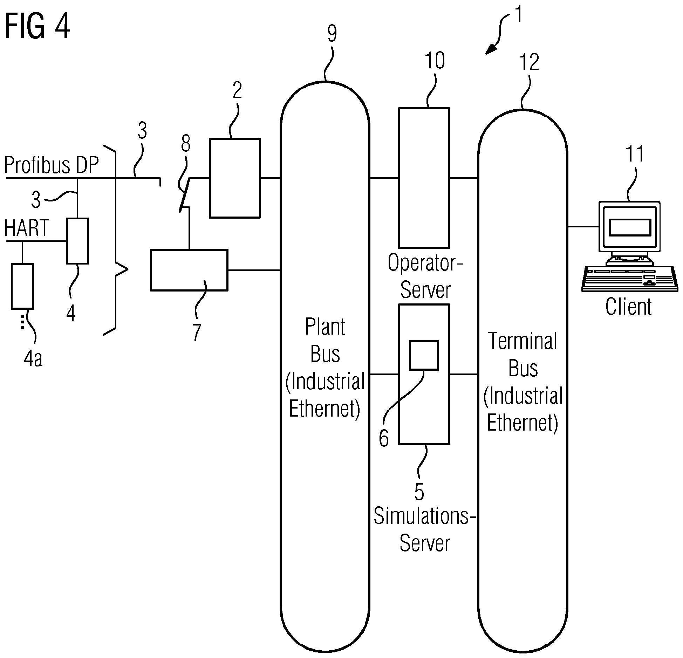

Es wird zunächst auf Figur 4 verwiesen, in der Bestandteile einer an sich bekannten Automatisierungseinrichtung 1 bzw. eines Prozessleitsystems dargestellt sind. Dieses weist eine speicherprogrammierbare Steuerung 2 (Automatisierungsgerät, Programmable Logic Controller - PLC) auf, welches über einen Feldbus 3 mit einer Feldebene in Form einer dezentralen Peripherie 4 mit an diese Peripherie 4 angeschlossenen Feldgeräten 4a verbunden ist. Die Feldgeräte 4a sind als hier nicht dargestellte Aktuatoren und Sensoren ausgebildet. Der Einfachheit halber und zur besseren Übersicht ist lediglich eine dezentrale Peripherie dargestellt. Selbstverständlich umfasst die Feldebene eine Vielzahl derartiger dezentraler Peripherien. Die dezentrale Peripherie 4 ist mit einer Interface-Baugruppe und mit einer Vielzahl von Prozesseingabe- und Prozessausgabe-Baugruppen versehen, wobei an die jeweiligen Prozesseingabe-Baugruppen die Sensoren und an die jeweiligen Prozessausgabe-Baugruppen die Aktuatoren angeschlossen sind. Über den Feldbus 3 kommuniziert die Interface-Baugruppe der dezentralen Peripherie 4 mit der übergeordneten Steuerung 2, wobei die Steuerung 2 über diese Interface-Baugruppe Prozesseingangswerte von den Sensoren empfängt, die an die Prozesseingangs-Baugruppen der dezentralen Peripherie 4 angeschlossen sind. Die Prozesseingangswerte verarbeitet ein auf der Steuerung 2 ablauffähiges Automatisierungs- bzw. Steuerprogramm, das aus diesen Prozesseingangswerten Prozessausgangswerte für die an den Prozessausgabe-Baugruppen der dezentralen Peripherie 4 angeschlossenen Aktuatoren erzeugt.

Um ein möglichst reales Verhalten der Feldebene vor dem eigentlichen Prozesssteuerbetrieb simulieren zu können, weist ein Simulations-Server 5 ein Simulations-Framework 6 zur Simulation des Prozessverhaltens der Feldebene auf. Dadurch wird die reale Feldebene virtualisiert bzw. nachgebildet um somit die Automatisierungseinrichtung 1 zu Testzwecken stimulieren zu können. Auf dem Simulations-Server 5 sind beispielsweise eine Vielzahl von einfachen Signalkurven oder reaktive Signal- bzw. Simulationsmodelle hinterlegt, wobei zur Verarbeitung der Simulationsmodelle jeweils ein Simulationsmodell in das Simulations-Framework 6 geladen wird. Mittels eines Simulations-Interfaces 7, welches zusammen mit dem Simulations-Framework 6 ein Simulations-Werkzeug repräsentiert, wird das Kommunikationsverhalten der realen Feldgeräte simuliert und das modellierte Prozessverhalten bzw. das zu verarbeitende Simulationsmodell an die Steuerung 2 angebunden. Während eines Simulations-Betriebs ist das Simulations-Interface 7 an Stelle der dezentralen Peripherie 4 (Feldebene) an den Feldbus 3 angeschlossen (in der Zeichnung durch eine geschweifte Klammer und einen Schalter 8 veranschaulicht), wobei das Simulations-Interface 7 simulierte Prozesseingangswerte der Steuerung 2 übermittelt und die Steuerung 2 aus den Prozesseingangswerten Prozessausgangswerte für die Aktuatoren erzeugt und die Prozessausgangswerte über das Simulations-Interface 7 dem Simulations-Framework 6 übermittelt. Ferner kommuniziert während dieses Simulations-Betriebs das Simulations-Interface 7 über den Feldbus 3 mit der Steuerung 2 und über einen Anlagenbus 9 mit einem Operator-Server 10. Dieser Operator-Server 10 bildet zusammen mit einem Operator-Client 11 ein Operator-System, welches zur Prozessführung und Prozessbeobachtung vorgesehen ist, wobei der Operator-Server 10 und der Operator-Client 11 an einen Terminal-Bus 12 angeschlossen sind. Selbstverständlich kann zur Kommunikation des Simulations-Interfaces 7 mit dem Simulations-Server 5 und dem Operator-Server 10 das Simulations-Interface 7 auch an den Terminal-Bus 12 angeschlossen sein.

Um den "Factory Acceptance Test-Anforderungen (FAT-Anforderungen) zu genügen, ist nachzuweisen, dass während des Tests bzw. während des Funktionsnachweises mit den dafür vorgesehenen, im Simulations-Server 5 hinterlegten Simulationsmodellen getestet wurde. Dieser Nachweis wird dadurch bewerkstelligt, indem auf dem Simulations-Server für die Simulationsmodelle jeweils Metadaten hinterlegt sind, die simulationsspezifische Informationen für das jeweilige Simulationsmodell beinhalten, wobei die Metadaten oder ein aus den Metadaten abgeleiteter Prüfwert dem Operator-Server übermittelt werden. Ferner werden die dem jeweiligen Simulationsmodell zugeordneten Metadaten oder der Prüfwert in einen Funktionsbaustein der Steuerung geladen, wobei die Metadaten oder der Prüfwert von dem Simulations-Framework über das Simulations-Interface der Steuerung bereitstellt werden, was bedeutet, dass die Metadaten oder der Prüfwert als Prozessdaten "getarnt" sind. Schließlich werden die in den Funktionsbaustein geladenen Metadaten (bzw. der geladene Prüfwert) in einem Prozessabbild des Operator-Servers hinterlegt und mit den vom Simulations-Server dem Operator-Server übermittelten Metadaten (bzw. mit dem Prüfwert) verglichen und das Vergleichsergebnis bewertet.

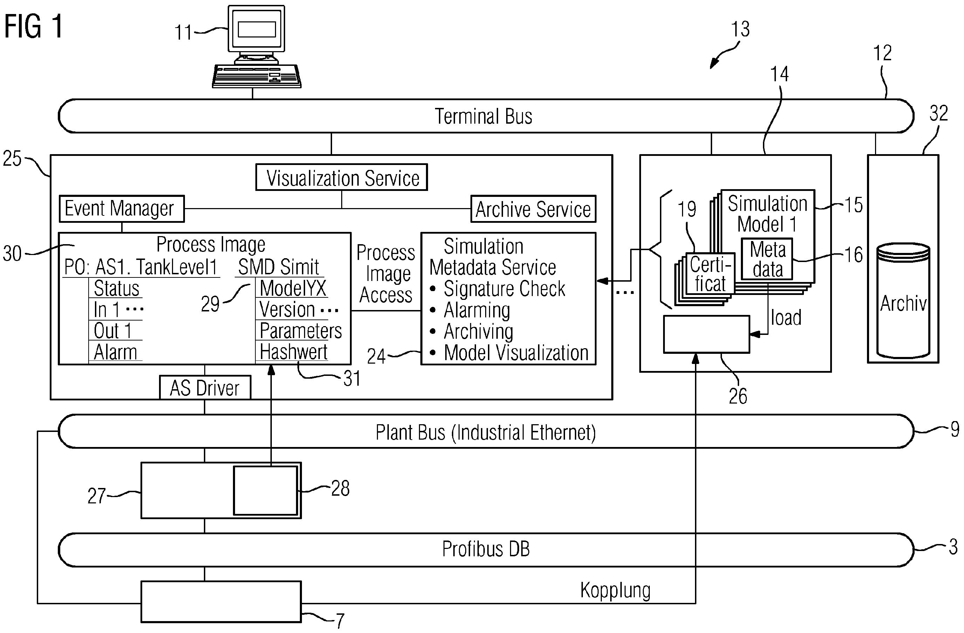

Zur näheren Erläuterung wird dazu auf Figur 1 verwiesen, in der Bestandteile einer Automatisierungseinrichtung 13 dargestellt sind.

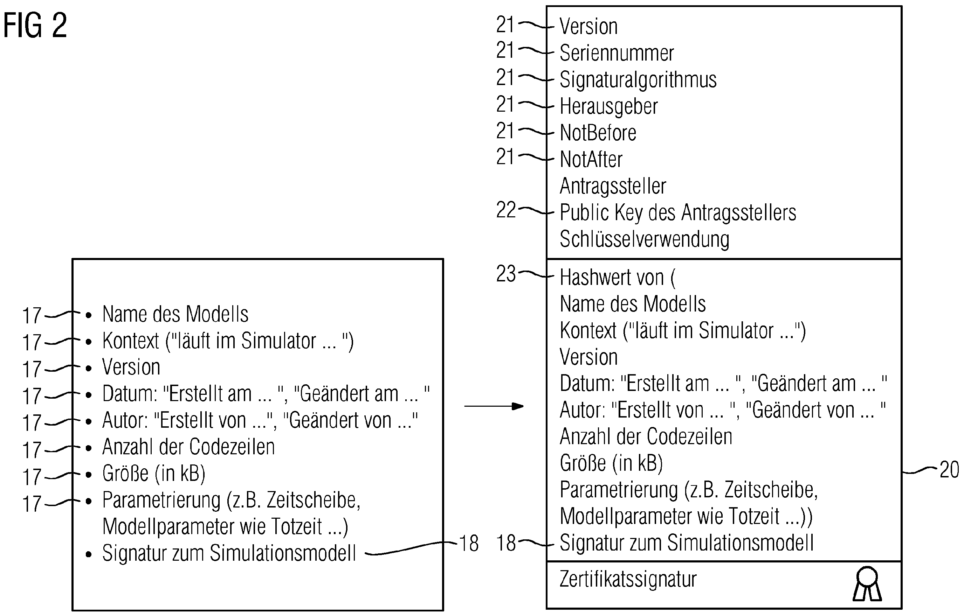

Zumindest für einen Teil der in einem Simulations-Server 14 abgespeicherten Simulationsmodelle 15 bzw. für die Simulationsmodelle, für welche der Funktionsnachweis zu dokumentieren ist, sind Metadaten 16 auf dem Server 14 hinterlegt, die simulationsspezifische Informationen für das jeweilige Simulationsmodell umfassen. Zum Beispiel beinhalten Metadaten 17 (Figur 2), die einem der Simulationsmodelle zugeordnet sind, den Namen dieses Simulationsmodells, Parameter sowie Autor und Erstellungsdatum des Modells. Jedem in Betracht zu ziehenden Simulationsmodell sind derartige Metadaten zugeordnet. Um zu verhindern, dass die Metadaten und die Simulationsmodelle 15 unautorisiert modifiziert werden und um das Original dieser Modelle 15 zu sichern, signiert beispielsweise ein Entwickler dieser Modelle 15 mit einem privaten Schlüssel - im Folgenden als erster privater Schlüssel bezeichnet - zunächst das jeweilige Simulationsmodell, wobei die Signatur und die Metadaten in einer Datei hinterlegt wird. Im vorliegenden Beispiel umfasst eine Datei die Metadaten 17 eines der Simulationsmodelle 15 und eine Signatur 18 dieses Modells.

Anschließend stellt eine vertrauenswürdige Zertifizierungsstelle (Certification Authority - CA) für die Simulationsmodelle 15 Zertifikate 19 aus, welche jeweils mit einem weiteren privaten Schlüssel - im Folgenden als zweiter privater Schlüssel bezeichnet - der Zertifizierungsstelle signiert sind. Die Zertifikate 19 beinhalten jeweils neben zertifikationsspezifischen Parameter einen zu dem ersten privaten Schlüssel passenden ersten öffentlichen Schlüssel und einen Prüfwert in Form eines Hash-Wert der Metadaten. Im vorliegenden Beispiel umfasst ein Zertifikat 20 des einen Simulationsmodells zertifikatsspezifische Parameter 21, einen zu dem ersten privaten Schlüssel passenden ersten öffentlichen Schlüssel 22 und einen Hash-Wert 23 der Metadaten 17.
Die Simulationszertifikate 19 übermittelt der Simulations-Server 14 vorzugsweise über den Terminal-Bus 12 einer Service-Einheit 24 eines Operator-Servers 25, in welchem in einem hier nicht dargestellten Zertifizierungsspeicher der zu dem zweiten privaten Schlüssel passende zweite öffentliche Schlüssel hinterlegt ist.

Im Folgenden wird angenommen, dass in einem Simulationsbetrieb das eine Simulationsmodell mit den dazugehörigen Metadaten 17 in ein Simulations-Framework 26 geladen und verarbeitet wird.
Das Simulations-Framework 26 übermittelt diese Metadaten 17 über das Simulations-Interface 7 einer Steuerung 27, welche die Metadaten 17 in einen Funktionsbaustein 28 hinterlegt. Die im Funktionsbaustein 28 hinterlegten Metadaten 17 überträgt die Steuerung 28 dem Operator-System 25, das die Metadaten 17 in eine Datenstruktur 29 eines Prozessabbildes 30 einträgt, wobei die Service-Einheit 24 mittels eines Dienstes "Signature Check" aus den Metadaten 17 einen Hash-Wert 31 erzeugt und in die Datenstruktur 29 einträgt.

Um den in der Datenstruktur 29 hinterlegten Hash-Wert 31 mit dem im Zertifikat 20 hinterlegten Hash-Wert 23 vergleichen zu können, prüft die Service-Einheit 24 zunächst mittels des Dienstes "Signature Check", ob das Zertifikat 20 von einer vertrauenswürdigen Zertifizierungsstelle erzeugt wurde, wobei der im Zertifizierungsspeicher des Operator-Systems hinterlegte zweite öffentliche Schlüssel für das Signaturverifikationsverfahrens benutzt wird.

Für den Fall, dass die Signaturverifikation ergibt, dass die Zertifikatssignatur gültig ist, so weist dies darauf hin, dass die Inhalte des Zertifikats 20 (zertifikatsspezifische Parameter 21, erster öffentlicher Schlüssel 22, Hash-Wert 23) nicht unberechtigt geändert bzw. manipuliert wurden. Aufgrund dessen, dass dann dem ersten öffentlichen Schlüssel 22 vertraut werden kann, verifiziert anschließend der Dienst "Signature Check" der Service-Einheit 24 mittels des im Zertifikat 20 hinterlegten ersten öffentlichen Schlüssels 22 die Signatur 18 des einen Simulationsmodells. Für den Fall, dass diese Signatur als gültig erkannt wird, vergleicht der Dienst "Signature Check" der Service-Einheit 24 den in der Datenstruktur 29 hinterlegten Hash-Wert 31 mit dem im Zertifikat 20 hinterlegten Hash-Wert 23. Stimmen die beiden Hash-Werte 23 und 31 nicht überein, deutet dies auf eine Manipulation des Simulationsmodells bzw. der Parameter dieses Simulationsmodells hin, d. h. das Simulationsmodells bzw. deren Parameter wurden unberechtigt geändert.

In diesem Fall triggert der Dienst "Signature Check" einen Dienst "Alarming" der Service-Einheit 24 des Operator-Systems 25, wobei dieser Dienst "Alarming" dem Operator-Client 11 einen Alarm übermittelt, der auf diesem Client visualisiert wird. Darüber hinaus leitet ein Dienst "Archiving" den von dem Dienst "Alarming" erzeugten Alarm einem Archiv-Server 32 weiter. Der Dienst "Archiving" ist ferner dazu ausgebildet, zur Laufzeit die im Archiv-Server 32 hinterlegten historischen Alarme bzw. Meldungen einer Simulation auszulesen, falls diese vom Operator-Client 11 angefordert werden.

Der Dienst "Alarming" erzeugt auch dann einen auf dem Client 11 zu visualisierenden und im Archiv-Server 32 zu hinterlegenden Alarm, falls beispielsweise während der Simulation ein Simulationsmodell getauscht wird, eine Signatur als nicht korrekt erkannt wurde, oder auch die Parameter des Simulationsmodells geändert werden. Aufgrund dessen, dass alle relevanten Änderungen während eines Factory Acceptance Tests gemeldet und archiviert werden, kann jederzeit nachvollzogen werden, auf welcher simulierten Grundlage eine Abnahme erfolgt ist.

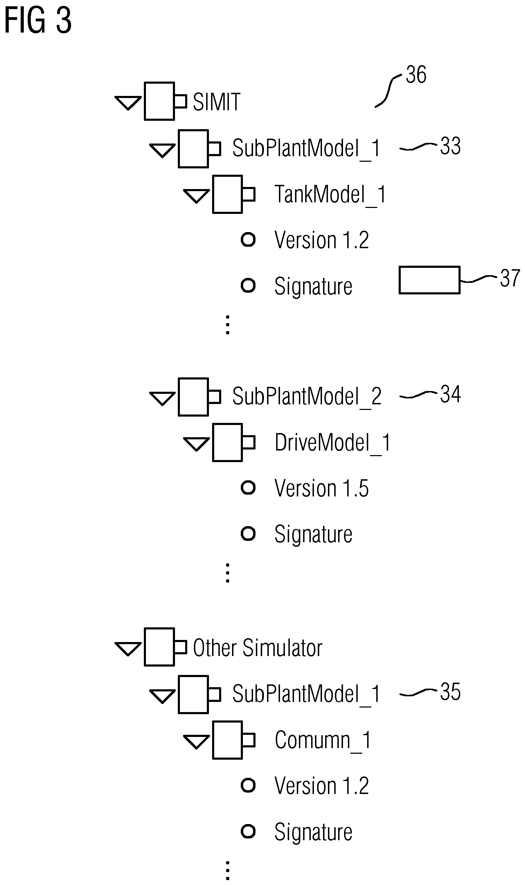

Um eine grafische und hierarchische Visualisierung der dem Factory Acceptance Test (FAT) zu Grunde liegenden Simulationsmodelle mit entsprechendem Status zu versehen, ist die Service-Einheit 24 mit einem Dienst "Model Visualization" versehen. Während des FATs werden die Simulationsmodell-Bezeichnungen 33, 34, 35 (Figur 3) mit dazugehörigen Parametern und Zustände auf dem Operator-Client 11 dargestellt. Der Visualisierung zu Grunde liegenden Simulationsmodelle eines FAT-Tests werden in Form einer hierarchischen Baumstruktur 34 einem Anwender auf dem Operator-Client 11 dargestellt. Diese hierarchische Baumstruktur 36 kann ebenfalls auf dem Archiv-Server 32 archiviert werden, um über vorgebbare Zeiträume Veränderungen der Simulationsmodelle im FAT nachvollziehen zu können. Im vorliegenden Beispiel erkennt der Anwender an einer Statuskennung 37, dass die Integrität, Authentizität und Echtheit des Simulationsmodells 33 nicht gegeben ist.

## Patentansprüche

1. Verfahren zum Betreiben einer Automatisierungseinrichtung, wobei die Automatisierungseinrichtung (13) versehen ist mit
- einem Simulations-Server (14), welcher aufweist ein Simulations-Framework (26) zur Simulation des Prozessverhaltens von Sensoren und/oder Aktuatoren gemäß einem Simulationsmodell, wobei im Simulations-Server eine Vielzahl von Simulationsmodellen (15) hinterlegt sind, welche in das Simulations-Framework (26) ladbar sind,
- einem Simulations-Interface (7) zum Simulieren des Kommunikationsverhaltens der Sensoren und/oder Aktuatoren und zum Anbinden des modellierten Prozessverhaltens an eine Steuerung (27), wobei das Simulations-Interface (7) simulierte Prozesseingangswerte der Steuerung (27) übermittelt und die Steuerung (27) aus den Prozesseingangswerten Prozessausgangswerte für die Aktuatoren erzeugt und die Prozessausgangswerte über das Simulations-Interface (7) dem Simulations-Framework (26) übermittelt, und
- einem Operator-System (11, 25) zur Prozessführung und Prozessbedienung,
**dadurch gekennzeichnet, dass**
- auf dem Simulations-Server (14) für mindestens einen Teil der Simulationsmodelle jeweils Metadaten (16, 17) hinterlegt werden, die jeweils einem der Simulationsmodelle (15) zugeordnet sind und jeweils simulationsspezifische Informationen für das jeweilige Simulationsmodell beinhalten, wobei ein von den Metadaten (16, 17) abgeleiteter Prüfwert (23) einer Service-Einheit (24) des Operator-Systems (11, 25) übermittelt wird,
- der dem jeweiligen Simulationsmodell zugeordnete Prüfwert (23) in einen Funktionsbaustein (28) der Steuerung (27) geladen wird, wobei der Prüfwert (23) von dem Simulations-Framework (26) über das Simulations-Interface (7) der Steuerung (27) bereitgestellt wird,
- der in den Funktionsbaustein (28) geladene Prüfwert (23) von der Steuerung (28) in einem Prozessabbild (30) des Operator-Systems (11, 25) hinterlegt wird, und
- mittels der Service-Einheit (24) des Operator-Systems (1, 25) der von dem Simulations-Server (14) übermittelte Prüfwert (23) mit dem von der Steuerung (28) im Prozessabbild (30) hinterlegten Prüfwert (23) verglichen wird.

2. Verfahren nach Anspruch 1, **dadurch gekennzeichnet, dass**
- das jeweilige Simulationsmodell mittels eines ersten privaten Schlüssels signiert wird,
- in die Service-Einheit (24) ein von dem Simulations-Server (14) übermitteltes und von einer vertrauenswürdigen Zertifizierungsstelle erstelltes Simulationsmodellzertifikat (20) für das jeweilige Simulationsmodell hinterlegt wird, wobei das Simulationsmodellzertifikat (20) als Prüfwert (23) einen Hash-Wert (23) der Metadaten (17) und einen zu dem ersten privaten Schlüssel passenden ersten öffentlichen Schlüssel (22) umfasst,
- durch die Service-Einheit (24) mittels eines in einem Zertifikationsspeicher des Operator-Systems (11, 25) hinterlegten zweiten öffentlichen Schlüssels eine Signaturverifikation des Simulationsmodellzertifikats (20) ausgeführt wird,
- durch die Service-Einheit (24) mittels des ersten öffentlichen Schlüssels (22) eine Signaturverifikation ausgeführt wird.

3. Automatisierungseinrichtung mit
- einem Simulations-Server (14), welcher ein Simulations-Framework (26) zur Simulation des Prozessverhaltens von Sensoren und/oder Aktuatoren gemäß einem Simulationsmodell aufweist, wobei im Simulations-Server eine Vielzahl von Simulationsmodellen (15) hinterlegt sind, welche in das Simulations-Framework (26) ladbar sind,
- einem Simulations-Interface (7) zum Simulieren des Kommunikationsverhalten der Sensoren und/oder Aktuatoren und zum Anbinden des modellierten Prozessverhaltens an eine Steuerung (27), wobei das Simulations-Interface (7) dazu ausgebildet ist, simulierte Prozesseingangswerte der Steuerung (27) zu übermitteln, und die Steuerung (27) dazu ausgebildet ist, aus den Prozesseingangswerten Prozessausgangswerte für die Aktuatoren zu erzeugen und die Prozessausgangswerte über das Simulations-Interface (7) dem Simulations-Framework (26) zu übermitteln, und
- einem Operator-System (11, 25) zur Prozessführung und Prozessbedienung,
**dadurch gekennzeichnet, dass**
- auf dem Simulations-Server (14) für mindestens einen Teil der Simulationsmodelle (15) jeweils Metadaten (16, 17) hinterlegt sind, die jeweils einem der Simulationsmodelle (15) zugeordnet sind und jeweils simulationsspezifische Informationen für das jeweilige Simulationsmodell (15) beinhalten,
- das Operator-System (11, 25) eine Service-Einheit 24) zum Hinterlegen eines von den Metadaten abgeleiteten Prüfwerts (23) aufweist,
- die Steuerung (27) mit einem Funktionsbaustein (28) zum Hinterlegen des dem jeweiligen Simulationsmodelle zugeordneten Prüfwertes (23) versehen ist, den das Simulations-Framework (26) über das Simulations-Interface (7) der Steuerung (27) bereitstellt,
- ein Prozessabbild (30) des Operator-Systems (11, 25) eine Datenstruktur (29) zum Laden des im Funktionsbaustein (28) hinterlegten Prüfwertes (23) aufweist, und
- die Service-Einheit (24) des Operator-Systems (11, 25) dazu ausgebildet ist, den vom Simulations-Server (14) übermittelten Prüfwert (23) mit dem von der Steuerung (28) im Prozessabbild (30) hinterlegten Prüfwert (23) zu vergleichen.

4. Automatisierungseinrichtung nach Anspruch 3, **dadurch gekennzeichnet, dass**
- die Metadaten (17) eine Signatur zu dem jeweiligen Simulationsmodell umfassen, wobei das eine Simulationsmodell mittels eines ersten privaten Schlüssels signiert ist,
- in der Service-Einheit (24) ein von dem Simulations-Server (14) übermitteltes und von einer vertrauenswürdigen Zertifizierungsstelle erstelltes Simulationsmodellzertifikat (20) für das jeweilige Simulationsmodell hinterlegt ist, welches als Prüfwert einen Hash-Wert (23) der Metadaten (17) und einen zu dem ersten privaten Schlüssel passenden ersten öffentlichen Schlüssel (22) umfasst, wobei in einem Zertifikationsspeicher des Operator-Systems ein zweiter öffentlicher Schlüssel zur Signaturverifikation des Simulationsmodellzertifikats (20) hinterlegt ist,
- die Service-Einheit (24) dazu ausgebildet ist, mittels des ersten öffentlichen Schlüssels eine Signaturverifikation auszuführen.

## Claims

1. Method for operating an automation facility, wherein the automation facility (13) is provided with
- a simulation server (14), which has a simulation framework (26) for simulation of the process behaviour of sensors and/or actuators according to a simulation model, wherein a large number of simulation models (15) is stored in the simulation server, and these can be loaded into the simulation framework (26),
- a simulation interface (7) for simulating the communication behaviour of the sensors and/or actuators and for connecting the modelled process behaviour to a controller (27), wherein the simulation interface (7) transmits simulated process input values of the controller (27) and the controller (27) generates process output values for the actuators from the process input values and the process output values are transmitted via the simulation interface (7) to the simulation framework (26), and
- an operator system (11, 25) for process control and process operation,
**characterised in that**
- stored on the simulation server (14) for at least some of the simulation models is metadata (16, 17) in each case, which is associated with one of the simulation models (15) in each case and contains simulation-specific information for the respective simulation model in each case, wherein a test value (23) derived from the metadata (16, 17) is transmitted to a service unit (24) of the operator system (11, 25),
- the test value (23) associated with the respective simulation model is loaded into a function block (28) of the controller (27), wherein the test value (23) is supplied by the simulation framework (26) via the simulation interface (7) to the controller (27),
- the test value (23) loaded into the function block (28) is stored in a process image (30) of the operator system (11, 25) by the controller (28), and
- by means of the service unit (24) of the operator system (1, 25), the test value (23) transmitted by the simulation server (14) is compared with the test value (23) stored in the process image (30) by the controller (28).

2. The method as claimed in claim 1, **characterised in that**
- the respective simulation model is signed by means of a first private key,
- a simulation model certificate (20) for the respective simulation model, transmitted by the simulation server (14) and created by a trusted certification authority, is stored in the service unit (24), wherein the simulation model certificate (20) comprises as a test value (23) a hash value (23) of the metadata (17) and a first public key (22) consistent with the first private key,
- a signature verification of the simulation model certificate (20) is performed by the service unit (24) by means of a second public key stored in a certification storage device of the operator system (11, 25),
- a signature verification is performed by the service unit (24) by means of the first public key (22).

3. Automation facility having
- a simulation server (14), which has a simulation framework (26) for simulation of the process behaviour of sensors and/or actuators according to a simulation model, wherein stored in the simulation server is a large number of simulation models (15), which can be loaded into the simulation framework (26),
- a simulation interface (7) for simulating the communication behaviour of the sensors and/or actuators and for connecting the modelled process behaviour to a controller (27), wherein the simulation interface (7) is embodied to transmit simulated process input values of the controller (27) and the controller (27) is embodied to generate process output values for the actuators from the process input values and the process output values are transmitted via the simulation interface (7) to the simulation framework (26), and
- an operator system (11, 25) for process control and process operation,
**characterised in that**
- stored on the simulation server (14) for at least some of the simulation models (15) is metadata (16, 17) in each case, which is associated with one of the simulation models (15) in each case and includes simulation-specific information for the respective simulation model (15) in each case,
- the operator system (11, 25) has a service unit 24) for storing a test value (23) derived from the metadata,
- the controller (27) is provided with a function block (28) for storing the test value (23) associated with the respective simulation model, which the simulation framework (26) supplies via the simulation interface (7) to the controller (27),
- a process image (30) of the operator system (11, 25) has a data structure (29) for loading the test value (23) stored in the function block (28), , and
- the service unit (24) of the operator system (11, 25) is embodied to compare the test value transmitted by the simulation server (14) with the test value stored in the process image (30) by the controller (28).

4. Automation facility according to claim 3, **characterised in that**
- the metadata (17) comprises a signature relating to the respective simulation model, wherein the one simulation model is signed by means of a first private key,
- stored in the service unit (24) is a simulation model certificate (20) for the respective simulation model, transmitted by the simulation server (14) and created by a trusted certification authority, which certificate comprises as a test value a hash value (23) of the metadata (17) and a first public key (22) consistent with the first private key, wherein stored in a certification storage device of the operator system is a second public key for signature verification of the simulation model certificate (20),
- the service unit (24) is embodied to perform a signature verification by means of the first public key.

## Revendications

1. Procédé pour faire fonctionner un dispositif d'automatisation, le dispositif (13) d'automatisation étant pourvu de
- un serveur (14) de simulation, qui a un framework (26) de simulation pour la simulation du comportement en processus de capteurs et/ou d'actionneurs suivant un modèle de simulation, une pluralité de modèles (15) de simulation, qui peuvent être chargés dans le framework (26) de simulation, étant mis en mémoire dans le serveur de simulation,
- une interface (7) de simulation pour simuler le comportement en communication des capteurs et/ou des actionneurs et pour rattacher le comportement en processus modélisé à une commande (27), l'interface (7) de simulation transmettant des valeurs simulées d'entrée de processus à la commande (27) et la commande (27) produisant, à partir des valeurs d'entrée de processus, des valeurs de sortie de processus pour les actionneurs et transmettant les valeurs de sortie de processus au framework (26) de simulation par l'intermédiaire de l'interface (7) de simulation, et
- un système-opérateur (11, 25) de conduite de processus et de service de processus,
**caractérisé en ce que**
- on met en mémoire, sur le serveur (14) de simulation, pour au moins une partie des modèles de simulation, respectivement, des métadonnées (16, 17), qui sont associées chacune à l'un des modèles (15) de simulation et qui contiennent chacune des informations spécifiques à la simulation pour le modèle de simulation respectif, une valeur (23) de contrôle, déduite des métadonnées (16, 17), étant transmise à une unité (24) de service du système-opérateur (11, 25),
- on charge la valeur (23) de contrôle, associée au modèle de simulation respectif, dans un module (28) de fonction de la commande (27), la valeur (23) de contrôle étant mise à disposition de la commande (27) par le framework (26) de simulation par l'intermédiaire de l'interface (7) de simulation,
- on met, dans une reproduction (30) de processus du système-opérateur (11, 25), par la commande (28), la valeur (23) de contrôle chargée dans le module (28) de fonction, et
- au moyen de l'unité (24) de service du système-opérateur (1, 25), on compare la valeur (23) de contrôle, transmise par le serveur (14) de simulation, à la valeur (23) de contrôle mise en mémoire dans la reproduction (30) de processus par la commande (28).

2. Procédé suivant la revendication 1, **caractérisé en ce que**
- on signe le modèle de simulation respectif au moyen d'une première clé privée,
- dans l'unité (24) de service, on met en mémoire un certificat (20) de modèle de simulation pour le mobile de simulation respectif, transmis par le serveur (14) de simulation et établi par un poste de certification digne de confiance, le certificat (20) de modèle de simulation comprenant, comme valeur (23) de contrôle, une valeur (23) de hash des métadonnées (17) et une première clé (22) officielle s'adaptant à la première clé privée,
- par l'unité (24) de service, on effectue, au moyen d'une deuxième clé publique mise en mémoire dans une mémoire de certification du système-opérateur (11, 25), une vérification de signature du certificat (20) de modèle de simulation,
- par l'unité (24) de service, on effectue une vérification de signature au moyen de la première clé (22) publique.

3. Dispositif d'automatisation, comprenant
- un serveur (14) de simulation, qui a un framework (26) de simulation pour la simulation du comportement en processus de capteurs et/ou d'actionneurs suivant un modèle de simulation, une pluralité de modèles (15) de simulation, qui peuvent être chargés dans le framework (26) de simulation, étant mis en mémoire dans le serveur de simulation,
- une interface (7) de simulation pour simuler le comportement en communication des capteurs et/ou des actionneurs et pour rattacher le comportement en processus modélisé à une commande (27), l'interface (7) de simulation étant constituée pour transmettre des valeurs simulées d'entrée de processus à la commande (27) et la commande (27) étant constituée pour produire, à partir des valeurs d'entrée de processus, des valeurs de sortie de processus pour les actionneurs et pour transmettre les valeurs de sortie de processus au framework (26) de simulation par l'intermédiaire de l'interface (7) de simulation, et
- un système-opérateur (11, 25) de conduite de processus et de service de processus,
**caractérisé en ce que**
- sur le serveur (14) de simulation sont mis en mémoire, pour au moins une partie des modèles (15) de simulation, respectivement des métadonnées (16, 17), qui sont associées chacune à l'un des modèles (15) de simulation et qui contiennent chacune des informations spécifiques à la simulation pour le modèle (15) de simulation respectif,
- le système-opérateur (11, 25) a une unité (24) de service pour la mise en mémoire d'une valeur (23) de contrôle déduite des métadonnées,
- la commande (27) est pourvue d'un module (28) de fonction pour la mise en mémoire de la valeur (23) de contrôle associée au modèle de simulation respectif, que le framework (26) de simulation met à disposition de la commande (27) par l'intermédiaire de l'interface (7) de simulation,
- une reproduction (30) de processus du système-opérateur (11, 25) a une structure (29) de données pour le chargement de la valeur (23) de contrôle mise en mémoire dans le module (28) de fonction, et
- l'unité (24) de service du système-opérateur (11, 25) est constituée pour comparer la valeur (23) de contrôle transmise par le serveur (14) de simulation à leur valeur (23) de contrôle mise en mémoire par la commande (28) dans la reproduction (30) de processus.

4. Dispositif d'automatisation suivant la revendication 3, **caractérisé en ce que**
- les métadonnées (17) comprennent une signature se rapportant au modèle de simulation respectif, le un modèle de simulation étant signé au moyen d'une première clé privée,
- dans l'unité (24) de service, un certificat (20) de modèle de simulation, transmis par le serveur (14) de simulation et établi par un poste de certification digne de confiance, est mis en mémoire pour le modèle de simulation respectif, certificat qui comprend, comme valeur de contrôle, une valeur (23) de hash des métadonnées (17) et une première clé (22) publique s'adaptant à la première clé privée, une deuxième clé publique étant, pour la vérification de signature du certificat (20) de modèle de simulation, mise en mémoire dans une mémoire de certification du système-opérateur,
- l'unité (24) de service est constituée pour effectuer une vérification de signature au moyen de la première clé publique.
